# EUROPEAN PATENT SPECIFICATION

(11) **EP 0 408 401 B1**
(45) Date of publication and mention of the grant of the patent: **22.03.1995**
(21) Application number: 90309322.7
(22) Date of filing: 22.06.1983
(51) Int. Cl.: G06F 15/02, H01H 13/70, H05K 3/12

(54) **A keyboard for an electronic apparatus**
Tastatur für einen elektronischen Apparat
Clavier pour appareil électronique

(30) Priority: 22.07.1982 US 401053; 01.11.1982 US 438066
(43) Date of publication of application: 16.01.1991
(62) Divisional of application: 83303591.8
(73) Proprietor: TEXAS INSTRUMENTS INCORPORATED, Dallas Texas 75265 (US)
(72) Inventor: Fiorella, Charles M., Sunrise, Florida 33313 (US); Chrobak, Michael J., Lubbock, Texas 79424 (US); Evans, Doyle R., Lubbock, Texas 79414 (US)
(74) Representative: Abbott, David John

(56) References cited:
- FR-A- 2 273 360
- GB-A- 2 013 402
- US-A- 4 304 973
- US-A- 4 319 099

## Description

The present invention relates to keyboards for electronic apparatuses such as hand held calculators, electronic learning aids and hand held electronic games. Construction of apparatuses of this type was disclosed in U.S. Patent No. 3,819,921 "Miniature Electronic Calculator" issued to Jack S. Kilby, Jerry D. Merryman and James H. Van Tassel on June 25, 1974. This patent discloses a hand held calculator including a keyboard input means, a visual display device and an integrated semiconductor circuit array located in substantially one plane including memory for storing entered digits, an arithmetic unit for performing calculations and a control unit controlling the transfer of data from the memory to the arithmetic unit and back to the memory.

Since the innovation described in U.S. Patent No. 3,819,921 major improvements in the computational ability and reductions in the cost of such apparatuses have been achieved. Heretofore such advances in the art of manufacture of miniature electronic apparatuses have come about due to improvements in the semiconductor art, specifically improvements in the complexity and reductions in the cost of integrated circuit semiconductor devices which form the primary electrical component of such apparatuses. Such innovations are exemplified by U.S. Patent No. 4,074,351 "Variable Function Programmed Calculator" issued to Gary W. Boone and Michael J. Cochran on February 14, 1978, which discloses an improved integrated circuit such as employed in apparatuses of this type. U.S. Patent No. 4,326,265 "Variable Function Programmed Calculator" issued to Gary W. Boone on April 20, 1982 discloses an electronic system which advantageously employs the integrated circuit taught in U.S. Patent No. 4,074,351.

The improvements in the semiconductor integrated circuit exemplified by the above cited patents have resulted in revolutionary improvements in apparatuses of this type. However, further improvements in semiconductor electronic technology presently yield decreasing benefits in the complexity and cost of such apparatuses, particularly in the field of low cost apparatuses. As a result, further decreases in cost will now become more dependent upon improvements in the manufacture of these apparatuses. This is because improvements in integrated circuit technology have proceeded at such a rapid pace that this area of the apparatus assumes a decreasing proportion of the total cost of manufacture. Thus improvements in the manufacture of such apparatuses assume a corresponding increasing importance in the total cost of such an electronic apparatus.

In the article entitled "Subassembly with parts, interconnects shaves cost of hand-held calculators", published in Electronics July 7, 1977 pages 42 and 44, there is described a hand-held calculator in which the interconnection wiring, the resistors and the keyboard contacts are printed on a flexible insulating substrate and the terminals of a calculator integrated circuit are connected to the wiring elements by pressure applied by clamping so that soldering is not required.

### SUMMARY OF THE INVENTION

It is an object of the present invention to provide a keyboard for an electronic apparatus, the keyboard including few piece parts and being specifically adapted for substantially automated assembly.

According to the present invention there is provided a keyboard structure for an electronic apparatus comprising:
a body of non-conductive material providing a keyboard surface;
an electrically conductive layer provided at a plurality of key switch positions on said body of non-conductivity material;
a keyboard sheet of non-conductive material having opposing first and second surfaces, said first surface being disposed adjacent to and substantially covering said keyboard surface;
an interconnection pattern including a plurality of electrical conductors disposed on said first surface of said keyboard sheet facing said keyboard surface and arranged to provide a pair of electrical conductors in proximity at each of said key switch positions and
said keyboard sheet including a plurality of keys, each of said keys being respectively provided with a pair of said electrical conductors on said interconnection pattern in proximity at each of said key switch positions such that actuation of a particular key on said keyboard sheet causes a respective pair of electrical conductors corresponding to a particular key switch position to be moved into engagement with said electrically conductive layer on said non-conductive keyboard surface to provide an electrical connection between said respective pair of conductors via said conductive layer at the selected key switch position; said body being provided with a plurality of spaced depressions formed therein to extend partially through the thickness thereof, said spaced depressions opening onto said keyboard surface and respectively located at corresponding key switch positions;
each of said electrically conductive layers being disposed at the bottom of respective depressions within said body of non-conductive material;
said keyboard sheet comprising a flexible membrane of non-conductive material; and
said flexible membrane flexing in a direction toward said keyboard surface of said body to move a respective pair of electrical conductors corresponding to a particular key switch position into engagement with said conductive layer disposed at the bottom of the depression located at the respective key switch position in response to pressure on said second surface of said flexible membrane selectively applied at said particular key switch position in providing the electrical connection between said respective pair of conductors via said conductive layer at the selected key switch position.

According to another embodiment of the present invention there is provided an electronic apparatus as defined in claim 3.

### BRIEF DESCRIPTION OF THE DRAWINGS

The present invention will be better understood from the following description of embodiments of the electronic apparatus taken in conjunction with the drawings in which:
FIGURE 1 is an exploded view of the major components of one embodiment of the electronic apparatus;
FIGURE 2 illustrates a preferred embodiment of a first conductive pattern;
FIGURE 3 illustrates the insulative pattern corresponding to the first conductive pattern illustrated in FIGURE 1;
FIGURE 4 illustrates the second conductive pattern or jumper pattern used in conjunction with the embodiments illustrated in FIGURES 2 and 3;
FIGURE 5 illustrates a preferred embodiment of the manner in which an integrated circuit is coupled to the interconnection pattern;
FIGURE 6 illustrates a preferred embodiment of the placement of the conductive adhesive on the connector portion of the interconnection pattern;
FIGURE 7 illustrates an alternative embodiment for connection of an integrated circuit to the interconnection pattern;
FIGURE 8 illustrates the preferred embodiment for connection of a liquid crystal display device to the interconnection pattern;
FIGURE 9 illustrates an alternative embodiment of the connection of an integrated circuit to the interconnection pattern employing a conductive elastomeric interface;
FIGURE 10 illustrates a preferred embodiment of the manner in which a pair of batteries are coupled to the interconnection pattern;
FIGURE 11 illustrates the detail of a spring employed for connection of batteries to the interconnection pattern;
FIGURE 12 illustrates a preferred embodiment of a key in the nondepressed or inactuated position;
FIGURE 13 illustrates the preferred embodiment of a key in the depressed or actuated position;
FIGURE 14 illustrates an electronic schematic diagram of a preferred embodiment of the apparatus;
FIGURE 15 illustrates an alternative embodiment for connection of an integrated circuit to the connector portion of the interconnection pattern;
FIGURE 16 illustrates the connection of a photovoltaic to the interconnection pattern;
FIGURE 17 illustrates an embodiment of the first interconnection pattern disposed on the first surface of the flexible membrane
FIGURE 18 illustrates the pattern of insulated layers disposed on first side of the flexible sheet;
FIGURE 19 illustrates the pattern of the second or jumper interconnection pattern disposed on the first surface of the flexible sheet;
FIGURE 20 illustrates an embodiment of the front portion of the exterior case of an electronic apparatus;
FIGURE 21 illustrates a cross-section of the single sheet membrane keyboard.

### DETAILED DESCRIPTION OF THE PREFERRED EMBODIMENT

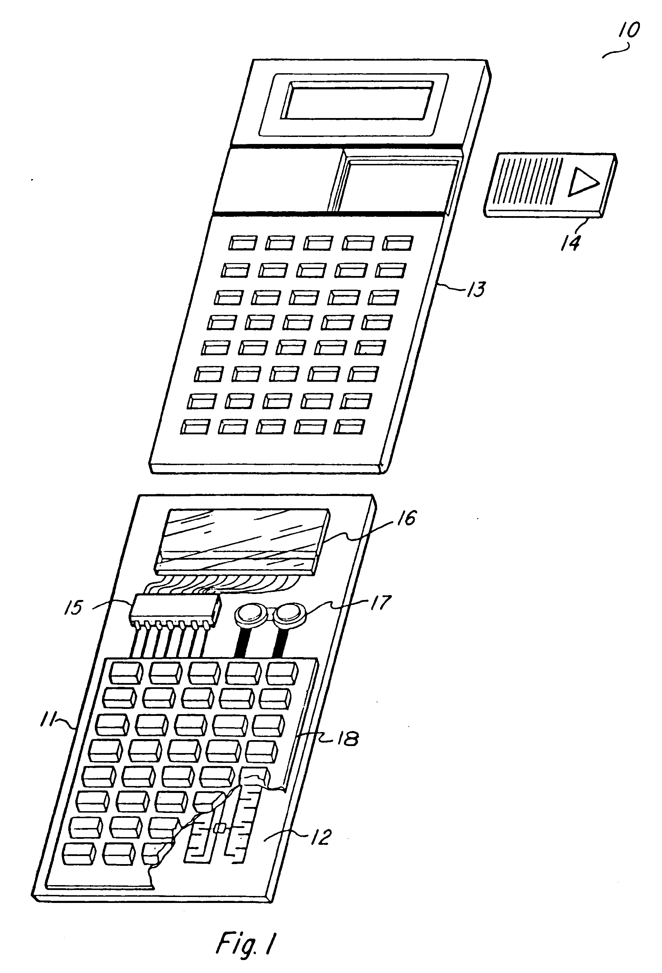

FIGURE 1 is an exploded view of the major components of an electronic apparatus. The electronic apparatus 10 includes bottom case 11, having a conductive interconnection pattern 12 imprinted thereon, a top case 13 and a battery door 14.

Major electrical components of the electronic apparatus are attached to bottom case 11. These electrical components include integrated circuit 15, display device 16 and a power source comprising a pair of batteries 17. These major components are interconnected in the proper manner via the interconnection pattern 12 printed on the bottom case 11.

The last major component of the electronic apparatus is keyboard 18. Keyboard 18 comprises a keyboard sheet having a plurality of keys. These keys are disposed in substantial alignment with key switch portions of inter-connection pattern 12 (further disclosed below) and also in registration with key holes disposed within top case 13.

Construction of the electronic apparatus 10 is achieved via a few simple steps. Bottom case 11 is formed including the conductive interconnection pattern 12. The major components, including an integrated circuit, a display device and batteries, are attached to the bottom case. Keyboard sheet 18 is sandwiched between the proper key switch areas within conductive interconnection pattern 12 and the key holes of top case 13 as bottom case 11 and top case 13 are joined together. Battery door 14 is inserted within top case 13 thereby properly aligning and connecting batteries 17.

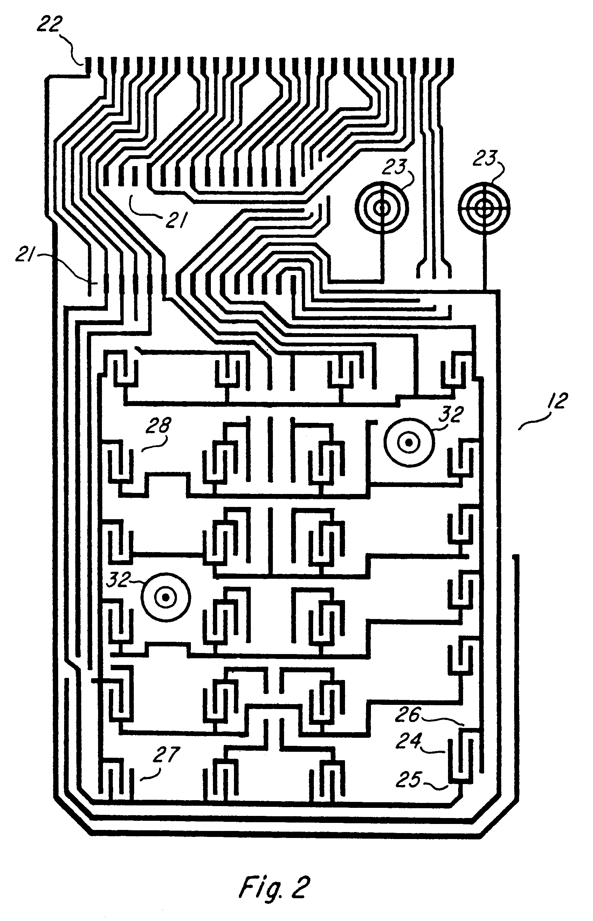

FIGURE 2 illustrates a preferred embodiment of a first conductive pattern. The interconnection pattern 12 imprinted on bottom case 11 includes a plurality of crossover portions. In this embodiment bottom case 11 must be constructed of nonconducting material. Each of these crossover portions requires one conductor to cross without electrically joining another conductor. In order to achieve such a crossover, it is necessary to provide two conductive patterns and one insulative pattern within the interconnection pattern 12. FIGURE 2 illustrates the first conductive pattern in such a system.

FIGURE 2 illustrates the first conductive pattern of interconnection pattern 12. This first conductive pattern includes substantially all of the primary interconnections with the exception of a number of jumpers in crossover positions within the interconnection pattern 12. Interconnection pattern 12 includes sets of connection conductors 21, 22 and 23 which are especially adapted for connect ion to major components of the electronic apparatus. Connection conductors 21, which are illustrated as including 28 conductors disposed in two rows of 14, are especially adapted for connection to an integrated circuit semiconductor device. Connection conductors 21 are disposed in a position for registration with the external leads of a 28 pin dual in line package integrated circuit. FIGURE 2 also illustrates connect ion conductors 22, which are especially adapted for connection to the display device. For example, the display device may comprise an eight digit liquid crystal display having seven segments for each digit as well as a decimal point. In addition a memory input indicator and a negative sign indicator may also be provided, making a total of 66 display segments. If these are accessed via a one third duty cycle drive method using 3 common lines and 26 select lines then a total of 29 connections is required. Connection conductors 22 illustrated in FIGURE 2 include 29 conductors disposed along one edge of the position for the display device. Lastly, interconnection pattern 12 includes connection conductors 23 which are specifically adapted for connection to the terminals of a pair of batteries employed as the power source of the apparatus.

Interconnection 12 illustrated in FIGURE 2 includes a plurality of kew switch positions 24. These key switch positions 24 are disposed in a matrix having six rows and four columns. Each key switch position 24 has a pair of conductors 25 and 26. The conductor 25 of each key switch position 24 is connected to a row conductor. The conductor 26 of each key switch position 24 is connected to a column conductor. These conductors 25 and 26 are disposed in an interleaved comb pattern whose purpose will be further described below.

In addition to the ordinary key switch positions 24 illustrated in FIGURE 2, FIGURE 2 further illustrates two special key switch positions 27 and 28. In accordance with the teachings of U.S. Patent No. 4,115,705 "Electronic Calculator with Push-Button On-Off System" issued to David J. McElroy September 19, 1978, the preferred embodiment of the electronic apparatus of the present invention includes momentary contact on and off switches. In accordance with the teachings of the above cited patent, key switch portions 27 and 28 (together with the other key switches 24 in the left most column) have one of the conductors connected to one terminal of the power supply, that is one of the two connection conductors 23 provided for connection to the pair of batteries. The other conductor of key switch portions 27 and 28 are connected to the column conductors in the manner of the other key switch positions 24. In accordance with the teachings of the above cited patent, the integrated circuit of the present apparatus is provided with a latch circuit having two stable conditions. Actuation of the key corresponding to key switch position 27 insures that the latch places the integrated circuit in the on condition. Actuation of the key corresponding to key switch positin 28 insures that the latch places the integrated circuit in the off state.

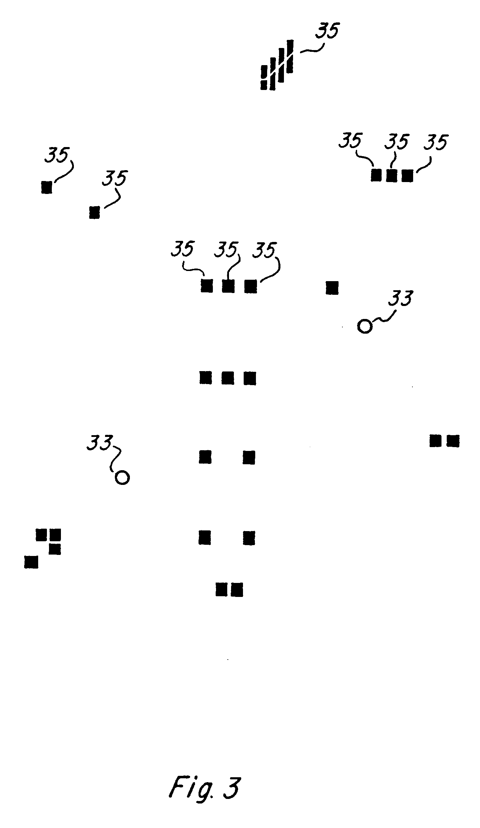

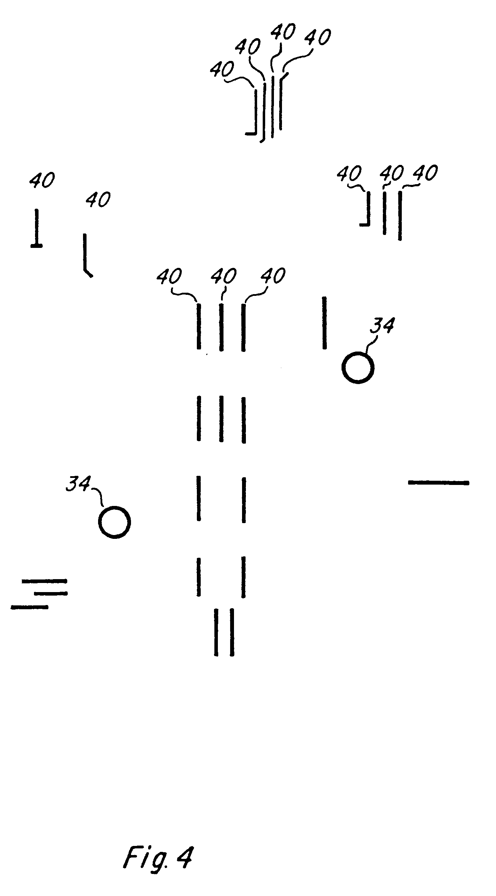

FIGURE 2 further illustrates concentric alignment patterns 32. Concentric alignment patterns 32 are employed in conjunction with similar concentric alignment patterns illustrated in FIGURES 3 and 4 as alignment gauges for the completed pattern. When the three layer interconnection pattern is complete concentric alignment patterns 32, 33 (illustrated in FIGURE 3) and 34 (illustrated in FIGURE 4) form a set of concentric circles, if the three printed layers were properly aligned. Because of the concentric circle pattern, it is very easy to distinguish misaligned patterns and reject a part having such a misaligned pattern.

FIGURE 3 illustrates the insulative pattern; The insulative pattern includes a plurality of insulators 35 which are disposed at predetermined crossover positions on the bottom case 11. Each of the insulators 35 is disposed to overlie and cover a small portion of the first conductive pattern illustrated in FIGURE 2. The insulative pattern also includes concentric alignment patterns 33.

FIGURE 4 illustrates the second conductive pattern or jumper pattern. The second conductive pattern includes a plurality of conductors 40. Each of these conductors 40 is disposed in a position to over lie the previously transferred insulators 35 illustrated in FIGURE 3. In addition, each of these conductors 40 extends beyond the ends of its corresponding insulator 35 to contact selected portions of the first conductive pattern illustrated in FIGURE 2. Using this technique the conductor 40 electrically connects to separate conductors of the first conductive pattern illustrated in FIGURE 2 while being insulated from a crossing conductor by virtue of the insulator 35. Thus this technique enables the contruction of an interconnection pattern 12 which is more complex than would be possible if such crossovers were not permitted. The second conductive pattern also includes concentric alignment pattern 34.

The three patterns illustrated in FIGURES 2, 3 and 4 are preferrably formed on the bottom case 11 via a pad transfer printing process. Initially the image to be transferred is etched into a steel cliche plate. Thus for example the image of the first conductive pattern illustrated in FIGURE 2 would be etched into a first cliche plate. This cliche plate is preferrably made of milled and hardened steel to permit long life. The depth of this etch is directly proportional to the amount of ink to be transferred from the cliche plate to the work piece, which is bottom case 11 in the preferred embodiment.

Once the cliche plates have been formed for the desired printed images, these cliche plates are placed upon an automatic printing apparatus which carries out the printing process. An ink reservoir is placed along one end of the cliche plate in a cliche holder assembly. This ink reservoir stores the particular ink to be employed in image of that particular plate. Firstly, a spatula blade is withdrawn from the ink reservoir and carries a thick layer of ink over the cliche plate. As the arm carrying the spatula is returned a thinner doctor blade wipes the cliche plate clean of ink except for the ink now stored within the etched portion of the plate. This etched portion of the plate has the image desired to be transferred to the work piece.

Next a soft silicon rubber transfer pad is pressed down and compressed over the cliche plate in the vicinity of the image etch. As the pad is withdrawn substantially all of the ink previously stored in the etched image of the cliche plate now adheres to the surface of the pad. Lastly, the pad is moved to the position of the work piece and is pressed down and compresses over the work piece. When the pad is withdrawn from the work piece substantially all of the ink previously held by the pad is now transferred to the surface of the work piece.

The ability to control the transfer of ink from the cliche plate to the pad to the work piece depends upon the relative adhesion of the ink to these surfaces. A steel cliche plate is ordinarily employed to insure that substantially all of the ink is removed from the etched image during the initial step. The particular composition of the silicon rubber pad is then selected in order to insure substantial removal of the ink from the etched image and also substantial transfer of this ink to the work piece.

In a typical practical machine which performs this printing process a single arm is employed for both the spatula and wiper blade and the transfer pad. Thus as the pad is withdrawn from the cliche plate and transferred to the site of the work piece, this arm also causes the spatula to transfer the ink to the cliche plate for the next printing. Upon removal of the pad from the work piece and withdrawal to the image on the cliche plate, the doctor blade also passes across the surface of the cliche plate to clean all of the ink except that stored within the etched portion. Thus the cliche plate is then ready for transfer of the next image. In addition, a practical printing machine of the type described will most often also include some form of automated work piece movement, so that a new work piece is presented at the printing site each time the pad is prepared for transfer of ink.

As will be clearly understood from a study of the above description in relation to FIGURES 2, 3 and 4, each bottom case 11 must undergo three separate printing processes as described above. The first conductive pattern illustrated in FIGURE 2 is transferred to the bottom case 11 followed by transfer of the insulative pattern illustrated in FIGURE 3 and lastly the second conductive illustrated in FIGURE 4 is transferred. The transfer printing process described above can be readily adapted to such a three step transfer printing process. This is easily achieved by providing three separate cliche plates with separate etches for each of the three patterns or one single cliche plate with three separate etched areas each corresponding to one of the patterns. Each separate cliche plate or etched area would employ its own ink reservoir having the proper ink for that particular pattern. The apparatus would be provided with three separate arms each having a spatula and doctor blade for properly applying the ink to the corresponding etched pattern and each having its own silicon rubber transfer pad for transfer of the ink of that particular pattern.

In a preferred embodiment, three separate work pieces would be employed simultaneously, one for each of the three separate patterns. A conductive ink would be transferred on to a first work piece according to the pattern illustrated in FIGURE 2, an insulative ink would be transferred on to a separate work piece in accordance with the pattern illustrated in FIGURE 3 and conductive ink would be transferred on to a third work piece in accordance with the pattern illustrated in FIGURE 4.

Upon withdrawal of the printing arms the work pieces would be transferred one station. This would place a new work piece at the station for receiving the first conductive pattern. In addition the work piece previously receiving the first conductive pattern would be placed in the center station to receive the insulative pattern. Lastly, the work piece which had just received the insulative pattern would be placed in the third work station in order to receive the second conductive pattern. The work piece which had previously received the second conductive pattern would be transferred out of the printing area as this work piece is complete.

As noted above the preferred embodiment for forming the interconnection pattern involves a pad transfer printing process. This process is advantageous in that it can readily accomodate surface irregularities in the work piece. For example, as noted below, the integrated circuit may be mounted in a depression 29 in bottom case 11 and the above described pad transfer printing process would enable easy formation of conductors between connection conductors 21 as shown in FIGURE 2 despite the presence of depression 29. However, if accomodation to surface irregularities is not required the patterns illustrated in FIGURES 2, 3 and 4 may be produced by other known methods such as silk-screening.

The ink employed in this interconnection pattern manufacture technique are of two types, solvent inks and ultraviolent light cured inks. In the case of solvent inks a preferred conductive ink is Dupont 4198. Dupont 4198 uses silver as its primary conductor and comprises approximately 70% silver suspended in butyl cellusolve acetate. After transfer of the ink to the work piece, the ink would cure by evaporation leaving the silver conductor behind. This solvent conductive ink could be employed for both the first conductive pattern and the second conductive pattern. A preferrable insulative ink is solder mask type LA from Weiderhold. This insulative ink is also of the solvent cure type.

Solvent inks of the type described above are constantly deteriorating due to premature curing prior to application to the work piece. The solvent in subsequent layers of solvent ink causes previously formed layers, even if fully cured, to deteriorate. Thus solvent inks are less desirable from a reliability standpoint than ultraviolent light cured inks. Ultraviolent light cured inks are formed of monomer molecules. Upon exposure to ultraviolent light of a proper wave length, intensity and duration, these monomers are formed into polymers which substantially fixes the ink pattern on to the work piece. A preferrable ultraviolent light conductor ink is Methode 6065E. Two preferrable insulator inks are Unimask 2000 and SPR-WE-7, both available from W. R. Grace. A preferrable manufacturing method when ultraviolent inks are employed would include an ultraviolent light source to cure the transferred patterns during the period while the work pieces are advanced to the next work station.

After the three layer interconnection pattern is formed as described above, it is preferrable that the pattern be tested to determine if they are properly formed. A visual test employing concentric interconnection patterns 32, 33 and 34 has been detailed above. It is preferrable that an electrical test also be performed. This may be achieved as an additional step following the three step printing process. An electrical probe is lowered to the completed bottom case having multiple probe tips contacting the conductive pattern at predetermined locations. It is possible using such an apparatus to rapidly test each crossover for proper electrical conduction through each of the jumpers illustrated in FIGURE 4 and for proper insulation by each of the insulators illustrated in FIGURE 3. This automated electrical test preferrably includes some technique for separating out the rejected bottom case automatically so that only properly constructed bottom cases are employed in the final assembly process.

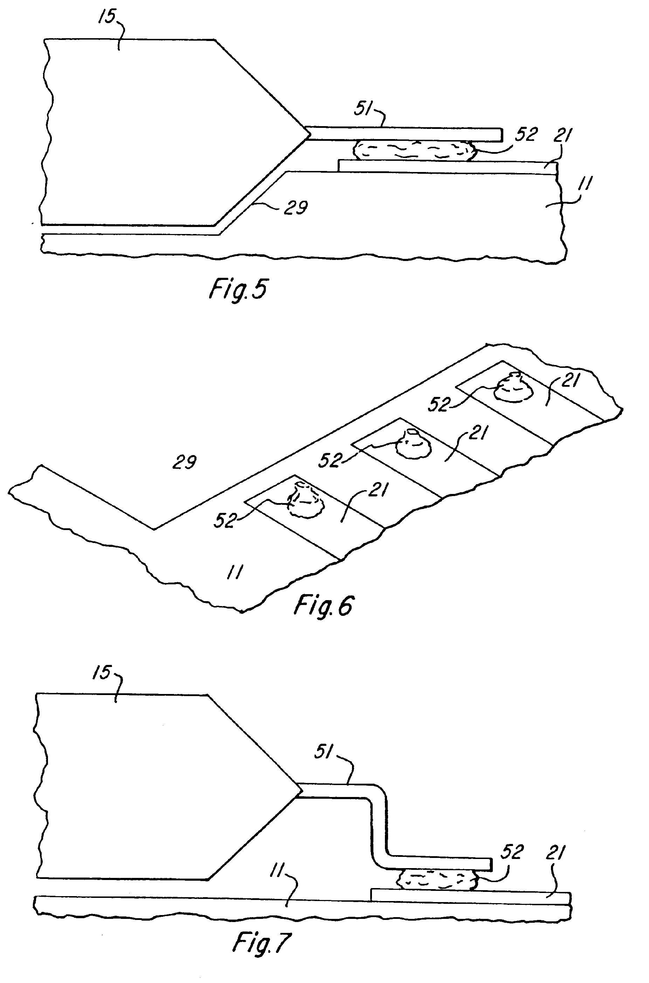

FIGURE 5 illustrates a preferred embodiment for attachment of the integrated circuit 15 to the bottom case 11. Integrated circuit 15 forms the major electrical component of the electronic apparatus of the present invention. As illustrated in FIGURE 2, the interconnection pattern printed on bottom case 11 includes a first set of connection conductors 21 for attachment to the leads of the integrated circuit 15. This connection is shown in cross section in FIGURE 5.

FIGURE 5 illustrates the details of the attachment of integrated circuit 15 to the first set of connector conductors 21 of the interconnection pattern. FIGURE 5 illustrates depression 29 within bottom case 11. Depression 29 is formed to substantially conform to the shape of integrated circuit 15. FIGURE 5 illustrates a cross sectional view of one side of a particular integrated circuit in a dual in line plastic package. Integrated circuit 15 includes leads 51 which protrude from the ends of the plastic package. Most dual in line integrated circuits are sold with the leads bent for easier insertion into a printed circuit board, however FIGURE 5 illustrates that lead 51 of integrated circuit 15 is straight and unbent. By careful matching of the known dimensions of the plastic case of integrated circuit 15 with the dimensions of depression 29 a small gap of known dimensions between lead 51 of integrated circuit 15 and conductor 21 printed upon bottom case 11 is formed. This small gap is filled by a conductive adhesive 52, which is illustrated in FIGURE 5 as adhering to both lead 51 and conductor 21. In addition, in a preferred embodiment, the plastic case of integrated circuit 15 is attached to the bottom of depression 29 by some other type of adhesive which serves as the major mechanical connection between integrated circuit 15 and bottom case 11. Many commercially available adhesives are suitable for this purpose and will not be described further.

FIGURE 6 illustrates the manner in which the conductive adhesive 52 is placed between the conductors of the integrated circuit and the interconnection pattern. FIGURE 6 illustrates a portion of bottom case 11 near depression 29, which is especially adapted for holding the integrated circuit 15. Along the edge of depression 29 are a plurality of conductors 21. Each of these conductors 21 forms a part of the interconnection pattern printed on bottom case 11. A small portion of conductive adhesive 52 is shown as placed at a predetermined spot on each of the conductors 21 near the edge of depression 29. These small portions of conductive adhesive 52 may be properly placed by a silk screen process or a mask printing technique. By properly placing a carefully controlled amount of conductive adhesive on conductors 21, it is possible to substantially fill the predetermined gap between connectors 21 and lead 51 while minimizing the possibility of shorts between adjacent connectors 21.

The above described embodiment for connecting integrated circuit 15 to the interconnection pattern 12 substantially reduces alignment problems. By proper correspondence of depression 29 to the known dimensions of the plastic case of integrated circuit 15 it is possible to constrain the possible positions of leads 51 so that they invaribly correspond to the proper conductors 21. Thus integrated circuit 15 could be hand placed within depression 28 of bottom case 11 or could be placed via automated machinery without requiring extremely close tolerances in the placement of the integrated circuit.

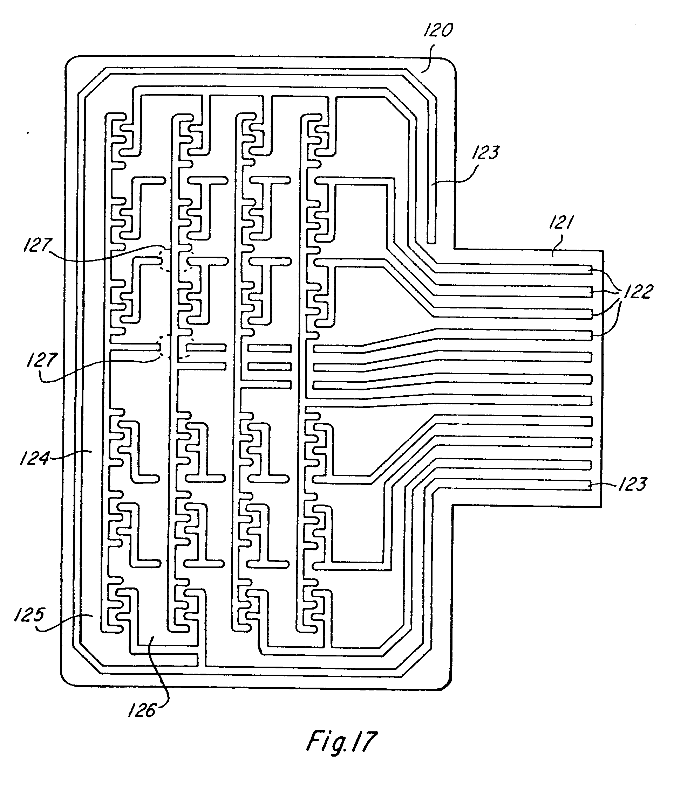

FIGURE 7 illustrates a cross sectional view of an alternative embodiment for attachment of integrated circuit 15 to the conductors 21. In accordance with the more normal practice, FIGURE 7 illustrates integrated circuit 15 having a bent lead 51. FIGURE 7 illustrates that integrated circuit 15 is placed upon bottom case 11 in a position so that leads 51 are substantially aligned with the corresponding connection portion 21. As illustrated in FIGURE 5, FIGURE 7 shows conductive adhesive 52 placed between lead 51 and conductor 21. As described above in conjunction with FIGURE 5, it is preferrable to include some form of mechanical adhesive between the plastic case of integrated circuit 15 and back case 11 to provide the major mechanical hold between these components. As an alternative, the major mechanical hold upon the integrated circuit may be achieved via a pressure fit between bottom case 11 and top case 13, perhaps employing a post such as post 94 illustrated in FIGURE 16. Therefore, the major task performed by conductive adhesive 52 is electrical connection between the integrated circuit and the interconnection pattern.

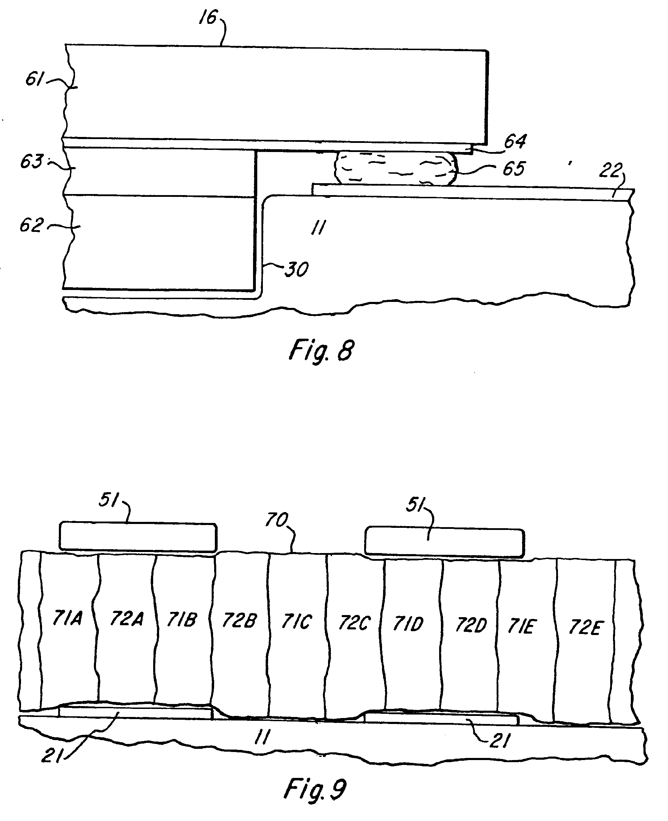

FIGURE 8 illustrates a cross sectional view of a preferred embodiment for attachment of a display device to interconnection pattern 12. Display device 16 is preferrably a liquid crystal display device. Display device 16 includes front glass plate 61 and back glass plate 62. Sandwiched between these two glass plates is a cavity 63 which includes the major components of the liquid crystal display including the electrodes and the liquid crystal chambers. In the cross section illustrated in FIGURE 8, electrode 64 is shown as adhering to one surface of glass plate 61 and emerging from chamber 63. It should also be noted that the upper glass plate 61 extends beyond the edge of the lower glass plate 62.

Bottom case 11 includes depression 30 constructed in order to accommodate the display device 16. Depression 30 is constructed of a depth compared to the known dimensions of display device 16 so that, when display device 16 is placed within depression 30, there is a predetermined gap between electrode 64 and conductor 22 deposited on bottom case 11. As described above in conjunction with the attachment of integrated circuit 15 to bottom case 11, a conductive adhesive 65 is disposed between the electrode 64 of the display device 16 and the conductor 22 disposed on bottom case 11. The conductive adhesive 65 may be initially placed on conductor 22 in the same manner as illustrated in FIGURE 6 and described above. In addition, in the manner described above in conjunction with attachment of integrated circuit 15, it is preferrable that another adhesive is employed to attach back plate 62 of display device 16 to the bottom of depression 30. By this manner, the major mechanical stress is taken by this mechanical adhesive and the major task fulfilled by conductive adhesive 65 is electrical connection of display device 16 to the interconnection pattern 12. As noted above in relation to mechanical support of the integrated circuit, as an alternative major mechanical support of display device may be provided by a press fit between bottom case 11 and top case 13.

In an alternative embodiment, the conductive adhesive employed for electrical connection of the integrated circuit or the display device may be replaced by a conductive elastomeric interface. A conductive elastomeric interface is made of alternating conductive and nonconductive layers of a flexible, elastic material. The integrated circuit or display device may be coupled to the corresponding connection conductors using such a conductive elastomeric interface having vertical layers. These vertical layers have a size which is less than the minimum spacing between the connection conductors or the leads of the electrical component. Preferrably the layers are sized so that a plurality of the conductive layers can be fitted into the width of one connection conductor or component lead.

FIGURE 9 illustrated the positioning of such a conductive elastomeric interface 70 between leads 51 and connection conductors 21 mounted on bottom case 11. Conductive elastomeric interface 70 includes conductive layers 71A, 71B, 71C, 71D and 71E sandwiched between insulative layers 72A, 72B, 72C, 72D and 72E. The leftmost lead 51 is electrically connected to the leftmost connection conductor 21 via conductive layers 71A and 71B. Similarly the rightmost lead 51 and the rightmost connection conductor 21 are electrically connected via conductive layers 71D and 71E. These connections are insulated from one another by insulative layers 72B and 72C. Because the distance between adjacent leads 51 and connection conductors 21 is greater than the width of a conductive layer, there is no possibility of shorting adjacent connections. The layer width has been selected relative to the width of leads 51 and connection conductors 21 so that at least one and often two conductive layers will make the electrical connection. So long as leads 51 and connection conductors 21 are substantially aligned, proper connections are formed no matter what the alignment of conductive elastomeric interface 70. Conductive elastomeric interface 70 is held in place by mechanical force provided by the mechanical adhesive or the pressure fit used to secure the electrical component.

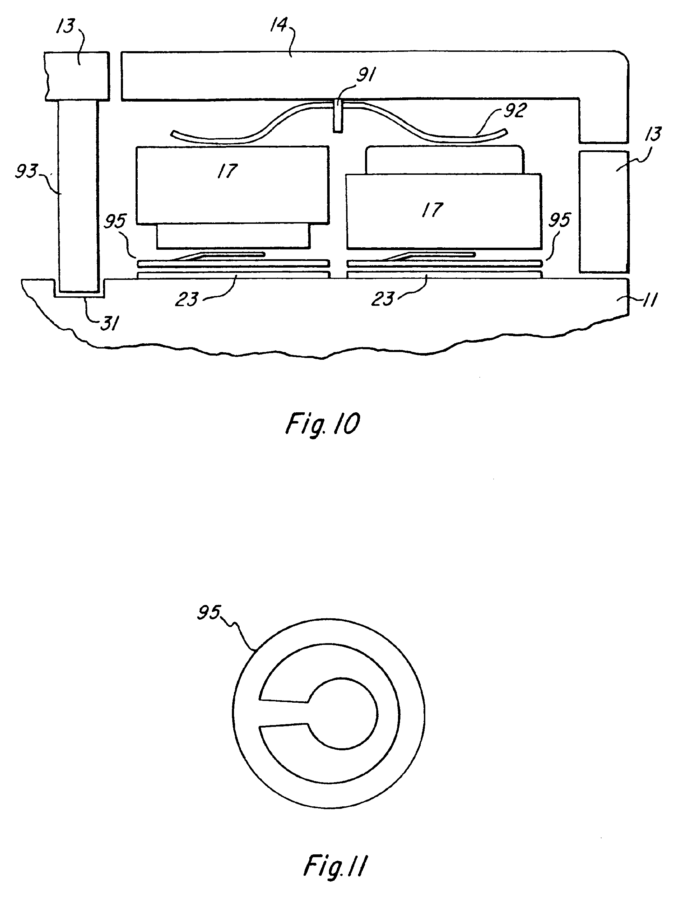

FIGURE 10 illustrates a cross sectional view of the manner of attachment of batteries 17 to the apparatus. FIGURE 10 illustrates bottom case 11, top case 13, battery door 14 and a pair of battery cells 17. Each of the battery cells 17 is disposed on and placed in electrical contact with one of the conductor 23 (see FIGURE 2). Conductors 23 serve as the means for connecting the power source represented by battery 17 to the circuit of the electronic apparatus.

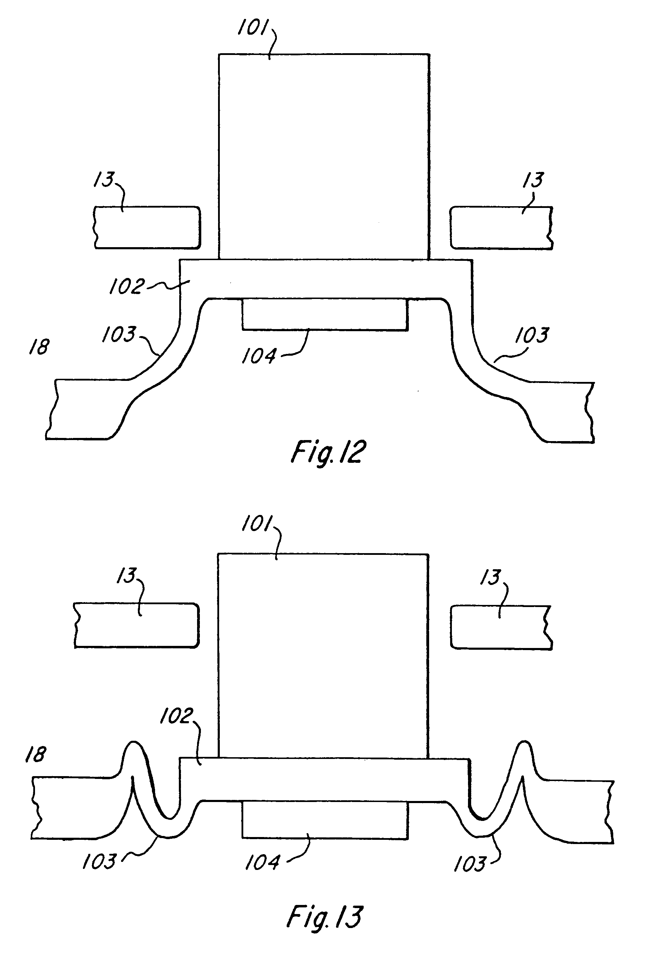

Battery door 14 preferrably includes a post 91 disposed on the interior surface thereof. A steel spring 92 is preferrably disposed on the interior surface of battery door 14 in contact with post 91. Post 91 serves as a tie point for securing spring 92 to the interior surface of battery door 14. As illustrated in FIGURE 10, spring 92 preferrably contacts one end of each of the batteries 17. Spring 92 thus performs two functions. Firstly, it provides electrical connection between one terminal of each of the batteries 17, thereby connecting these batteries in series across the two conductors 23. In addition, steel spring 92 is preferrably constructed in order to provide some mechanical force pressing battery 17 into the conductors 23. This mechanical force is advantageous in assuring proper electrical contact of the batteries 17 in series across conductors 23. Additionally, steel springs 95 may be disposed between each battery 17 and its corresponding connection conductor 23. Steel springs 95 supply additional mechanical force for retaining batteries 17, and further supply some mechanical compliance enabling batteries 17 to move during mechanical shock and recover with proper electrical connection. Steel springs 95 are preferrably formed of stamped sheet metal as illustrated in FIGURE 11 and are connected to connection conductors 23 via conductive adhesive. Alternately, if addition shock absorption capacity is not required, batteries 17 may be directly connected to connection conductors via conductive adhesive.

In the preferred embodiment battery door 14 has lips which slide in grooves within top case 13 in order to secure battery door 14 in top case 13. Spring 92 and 95 preferrably are compressed during this operation, thereby generating the above described force and also tending to hold battery door 14 in place.

FIGURE 10 illustrates additional features which tend to secure batteries 17 from lateral motion. Firstly, the right most battery 17 is prevented from extreme motion to the right via the end portion of top case 13 which forms the side of the electronic apparatus. In addition, the left most battery 17 is restrained from movement to the left via post 93 formed in top case 13. Post 93 is illustrated as extending from top case 13 and resting within depression 31 within bottom case 11. Bottom case 11 has a plurality of depressions 31 which are disposed in position corresponding to post 93 of top case 13. This combination of post 93 and depression 31 enables substantial mechanical contact between bottom case 11 and top case 13. This substantial mechanical contact greatly facilitates the mechanical connection of bottom case 11 to top case 13. One or more post 93 with corresponding depressions 31 may be disposed in positions adjacent to the positions of batteries 17 in order to restrain lateral movement of batteries 17.

FIGURES 12 and 13 illustrate the operation of one key of the keyboard sheet 18. FIGURE 12 illustrates the key in the nondepressed, inactuated state and FIGURE 13 illustrates the key in the depressed, actuated state.

Keyboard sheet 18 includes a plurality of key tops 101 which are disposed within the interior of the electronic apparatus and extend through key apertures within top case 13. Each key top 101 has a corresponding major plate 102 which lies beneath the aperture through top case 13 and substantially restrains additional vertical movement through the aperture. Each key includes a flexible portion 103 around the periphery of major plate 102 for attachment of the particular key to keyboard sheet 18. Flexible portion 103 includes a reduced cross sectional dimension which permits substantial flexure in the vertical direction when pressure is applied to the top of key top 101. At the bottom of major plate 102 is a conductive portion 104 which is constructed of a conductive material and which is disposed in alignment with each of the key switch areas 24, 27 and 28 illustrated in FIGURE 2.

The ordinary operation of each key is as follows. The flexible portion 103 urges the major plate 102 upward toward the aperture within top case 13. This causes key top 101 to be fully extended and more importantly prevents conductive portion 104 from contact with the particular key switch position below. Upon application of vertical pressure to key top 101, flexible portion 103 is strained until it undergoes a folding state as illustrated in FIGURE 13. Upon achievement of the folding state, key top 101 as well as major plate 102 and conductive portion 104 are forced downward until conductive portion 104 contacts the pair of conductors 25 and 26 of the corresponding key switch position 24, 27 or 28. This contact causes electrical conduction between conductors 25 and 26. Note that conductors 25 and 26 are formed in an interleaved comb pattern in order to assure a greater reliability in switch closure by creating a longer periphery where conductors 25 and 26 are adjacent. This electrical conduction is sensed by integrated circuit 15 as a key switch closure. In accordance with the construction of integrated circuit 15, this key switch closure is interpreted as entry of data or commands.

During this time the flexible portion 103 is under considerable stress and resists this stress with upward pressure upon major plate 102. Release of the vertical pressure on key top 101 causes flexible portion 103 to urge major plate 102 upward towards its rest position. As a result, conductive portion 104 is no longer placed in contact with the pair of conductors 25 and 26, thereby breaking the electrical connection.

The sudden switch between the substantially flat state of flexible portion 103 illustrated in FIGURE 12 to the folded or warped state illustrated in FIGURE 13, generates a substantial positive feel to the finger employed for depression of key top 101. This keyboard feel enables feedback to the operator that the key switch has been depressed.

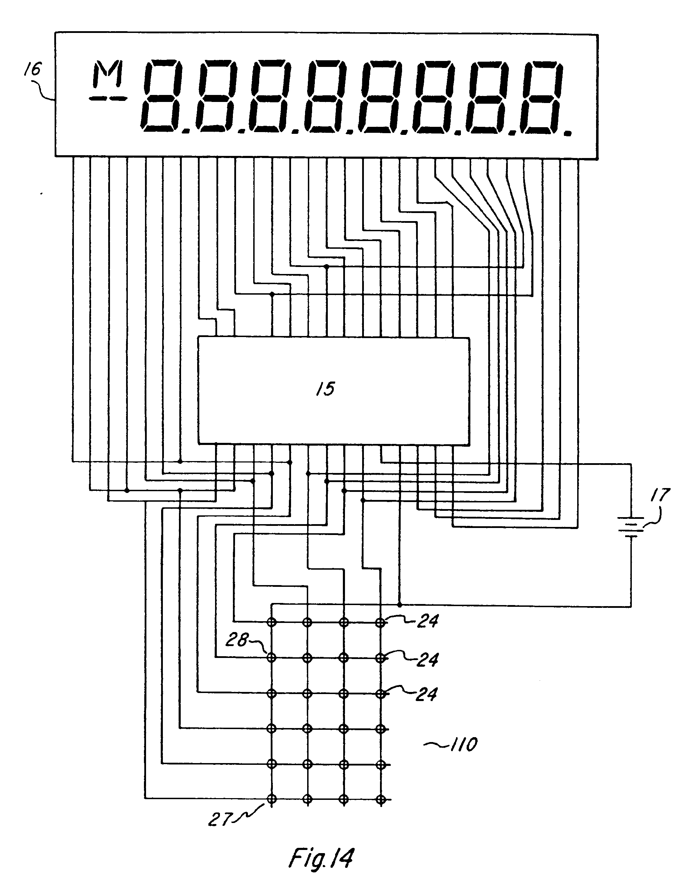

FIGURE 14 illustrates an electrical schematic diagram of a preferred embodiment of the electronic apparatus constructed in accordance with the present invention. Note that the schematic diagram illustrated in FIGURE 14 is embodied in the three patterns forming the interconnection pattern illustrated in FIGURES 2, 3 and 4.

FIGURE 14 illustrates electronic apparatus 10. Electronic apparatus 10 includes integrated circuit 15, display device 16, power supply 17 and a keyboard 110 including keys 24, 27 and 28. Integrated circuit 15 is illustrated as including 28 pins. In accordance with the teachings of U. S. Patent No. 4,242,657 "Display and Keyboard Scanning for Electronic Calculator or the Like" issued to Gary W. Boone and Michael J. Cochran on December 30, 1980, integrated circuit 15 includes a combined display and keyboard scan. One set of pins from integrated circuit 15 are attached directly to display device 16. Display device 16 is illustrated as including eight seven-segment digits with decimal points with the addition of a memory indicator and a negative sign indicator. FIGURE 14 illustrates another set of terminals from integrated circuit 15 are applied to the column conductors of the keyboard 110. A third set of terminals from integrated circuit 15 are applied in parallel to terminals of display device 16 and to the row conductors of keyboard 110. This circuit permits integrated circuit 15 to generate combined keyboard and display scan signals on the common lines for application to both keyboard 110 and display device 116. Actuation of any key from keyboard 110 is recognized by sensing the voltage on the keyboard column conductors. The lines from integrated circuit 15 which are applied directly to display device 16 provide display information in conjunction with the scan signals for generating the desired visual display. The combined system illustrated in FIGURE 14 is constructed in accordance with the teachings of U. S. Patent 4,326,265 "Variable Function Programed Calculator" issued to Gary W. Boone on April 20, 1982.

In some cases it is necessary to depart from the circuit illustrated in FIGURE 14 by provision of one or more discrete components external to integrated circuit 15. For example, it may desirable to substitute a photovoltaic cell power supply for the batteries 17 illustrated in FIGURE 14. In such a case it is easy to provide a photovoltaic cell sufficiently large to generate the average power required by the integrated circuit. However, in some instances the peak power required by the integrated circuit will exceed the power which can be generated by a reasonably sized photovoltaic cell. In such a case it is desirable to provide a capacitor external to the integrated circuit to store charge and thereby smooth out the power requirements of the system and permit it to be powered by a photovoltaic cell. In such a case it is necessary to provide a means for attachment of this discrete component external to the integrated circuit device.

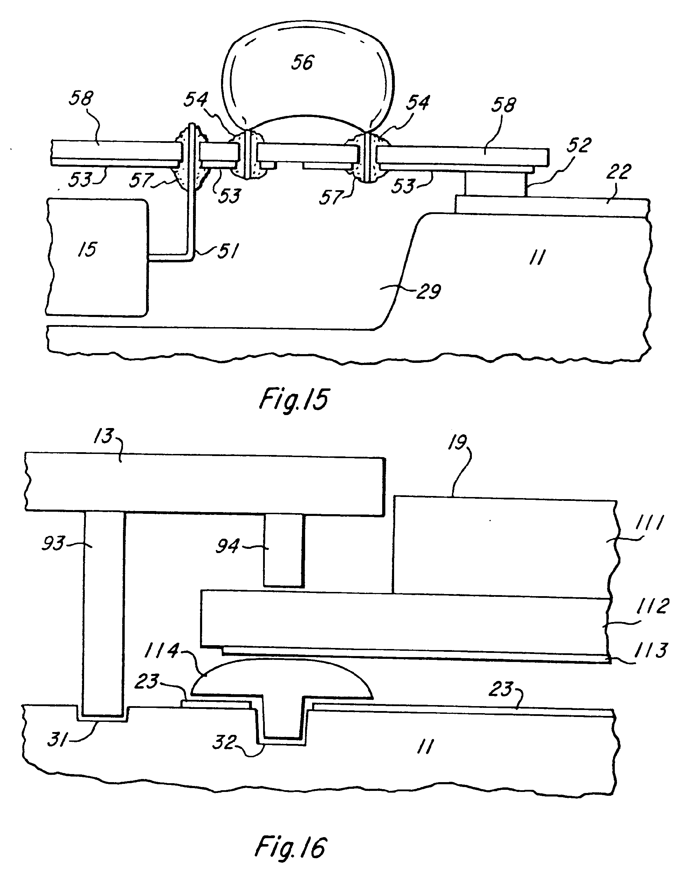

FIGURE 15 illustrates a preferred embodiment of the manner of connecting an integrated circuit and an external discrete component to the interconnection pattern 12 printed on bottom case 11. This technique includes the use of a small printed circuit board 58 to hold both the integrated circuit 15 and the discrete component.

FIGURE 15 illustrates an embodiment of integrated circuit 15 formed in a flat pack case. The cross sectional view of FIGURE 15 shows lead 51 emerging from one end of integrated circuit 15 which passes through an aperture in printed circuit board 58. The lower surface of printed circuit board 58 includes a conductive printed pattern 53 constructed in a conventional manner. Integrated circuit lead 51 is electrically coupled to interconnection pattern 53 via solder 57 in accordance with known techniques.

FIGURE 15 also illustrates external component 56, which may be a disk capacitor, mounted on printed circuit board 58. Capacitor 56 includes leads 54 which pass through apertures within the printed circuit board 58. These leads 54 are coupled to portions of interconnection pattern 53 via solder 57 in the same manner as attachment of the intergrated circuit leads 51. Although capacitor 56 is illustrated as mounted on the reverse side of printed circuit board 58 from the integrated circuit 15, these components may be mounted on the same side depending upon the clearance afforded by depression 29.

FIGURE 15 illustrates bottom case 11 having depression 29 for mounting the combined structure attached to printed circuit board 58. Depression 29 has a depth so that integrated circuit 15 may be adhered to the bottom of depression 15 while providing a predetermined gap between interconnection pattern 53 mounted on the bottom side of printed circuit board 58 and conductor 22 of interconnection pattern 12 mounted on the top surface of bottom case 11. As in the case of mounting the dual in line package integrated circuit 15, a suitable mechanical adhesive is employed to attach integrated circuit 15 to an appropriate position in depression 24. A small amount of conductive adhesive 52, deposited in the same manner as illustrated in FIGURE 6, serves to electrically couple the predetermined lines of interconnection pattern 53 and conductors 22. As noted above with respect to other components, the printed circuit board 58 may be secured via a pressure fit and connected via a conductive elastomeric interface as alternative embodiments.

FIGURE 16 illustrates a preferred embodiment of the manner of mounting a photovoltaic cell within the electronic apparatus. FIGURE 16 illustrates bottom case 11, top case 13 and photovoltaic cell 19.

Photovoltaic cell 19 includes a photovoltaic layer 111 which includes the electrical power generation circuit. This photovoltaic layer 111 is mounted on a back plate 112 which provides major mechanical support for the photovoltaic cell 19. Note that back plate 112 is disclosed as extending beyond the edge of photovoltaic layer 111. In the preferred embodiment an aperture is disposed within top case 13 sufficient to permit external ambient light to fall on photovoltaic layer 111. At the same time, the ends of back plate 112 extend beyond the dimensions of the aperture and enable mounting of the photovoltaic cell 19. FIGURE 16 further illustrates electrical lead 113 disposed upon the lower surface of back plate 112.

FIGURE 16 illustrates top case 13 which includes posts 93 and 94. In accordance with the matter illustrated in FIGURE 10, post 93 is disposed in and received by depression 31 within bottom case 11. As taught in conjunction with the matter illustrated in FIGURE 10, post 93 may be disposed in this position to limit the lateral motion of photovoltaic cell 19. Post 94 is disposed in a position which substantially opposes a depression 32 within bottom case 11. Post 94 has a height selected to engage the end of back plate 112 and substantially limit the vertical motion of photovoltaic cell 19.

The major electrical connection between photovoltaic cell 19 and interconnection pattern 12 is illustrated in FIGURE 16. Interconnection pattern 12 disposed on bottom case 11 includes conductor 23 for connection to the voltage source. Disposed between conductor 23 and electrical terminal 113 of photovoltaic cell 19 is a mushroom shaped connector 114. This mushroom shaped connector 114 has a stem which extends into the depression 32 within bottom case 11. Connector 114 includes a crown portion whose bottom is placed in substantial contact with conductor 23 and whose top is placed in substantial contact with electrical lead 113. Connector 114 is preferably constructed of a conductive silicon rubber which is highly elastic.

The combination illustrated in FIGURE 16 is assembled as follows. Firstly, the stem portion of connector 114 is disposed in the corresponding depression 32 within bottom case 11. Next photovoltaic cell 19 is placed on top of the connector 114 so that lead 113 is in substantial contact with the top of connector 114. Lastly, top case 13 is aligned and connected to bottom case 11. This preferably causes post 94 to press back plate 112 to slightly compress connector 114. This compression causes connector 114 to exert a force on both conductor 23 and lead 113, thereby electrically connecting these structures. It should be understood that FIGURE 16 illustrates only one of at least two required connections for photovoltic cell 19. Another connection of substantially the same type is preferably provided between photovoltaic cell 19 and the interconnection pattern 12 in order to provide a complete circuit.

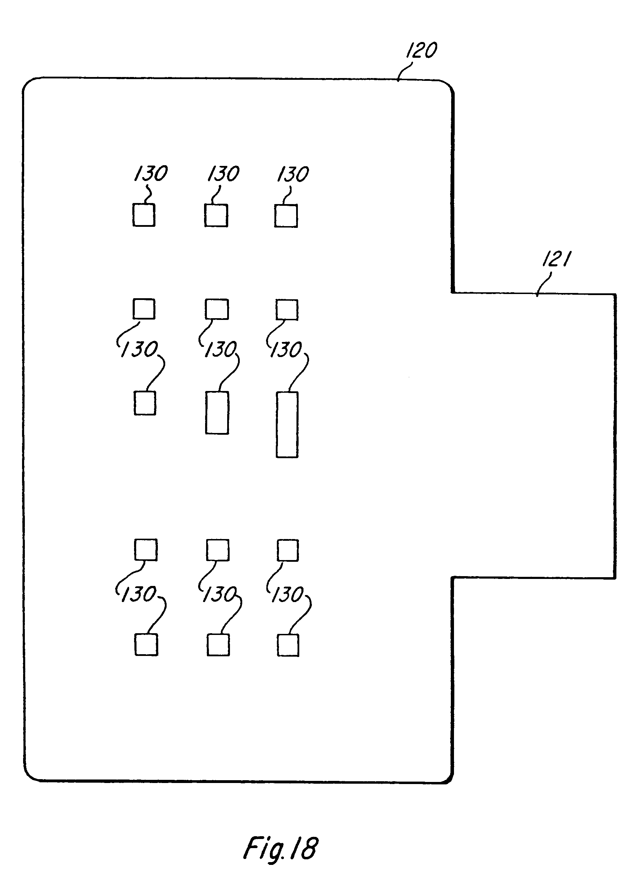

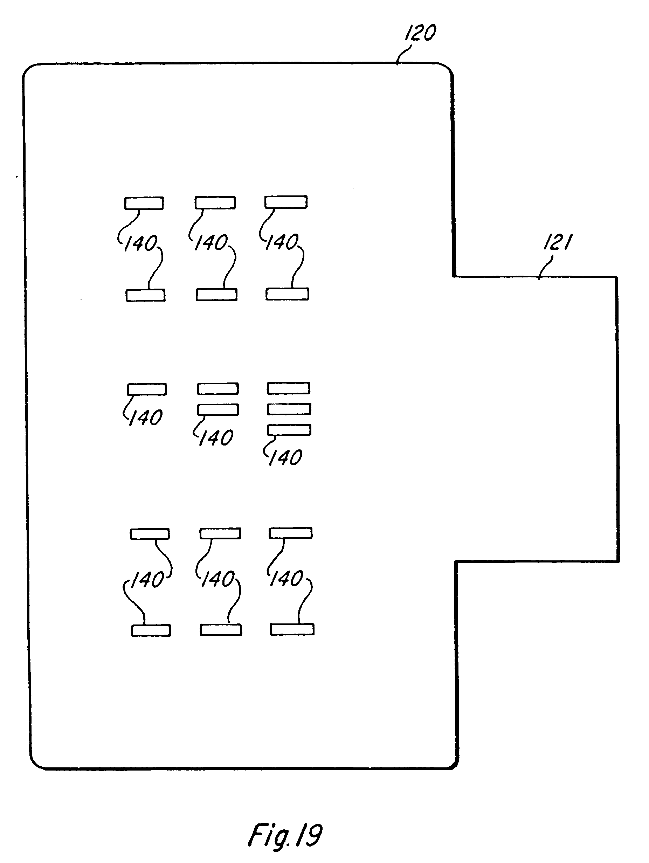

FIGURES 17, 18 and 19 illustrate the patterns necessary to construct a twenty four key matrix keyboard on a single sheet. FIGURE 17 illustrates a first conductive pattern. FIGURE 18 illustrates an insulative pattern. FIGURE 19 illustrates a second conductive pattern or jumper pattern.

FIGURE 17 illustrates the first conductive pattern on the flexible sheet 120. Flexible sheet 120 includes a tail portion 121 and has an interconnection pattern disposed thereon including a plurality of conductors 122. The first conductive pattern on flexible membrane 120 includes a plurality of key switches 124. Each key switch 124 has a pair of conductors arranged in an interleaved comb pattern.

The first conductive pattern illustrated in FIGURE 17 includes conductor 123 which is disposed around the periphery of the first surface of flexible membrane 120. This conductor 123 is connected to one of the pair of conductors of key switches 125 and 126. Conductor 123 is preferrably connected to one terminal of the power supply and provides a ground plane for the keyboard. This ground plane is necessary to minimize the buildup of static charge which is particularly troublesome if the electronic apparatus includes one or more metal oxide semiconductor devices which are sensitive to static charge.

In accordance with the teachings of U.S. Patent No. 4,115,705 "Electronic Calculator with Push-Button On-Off System" issued September 19, 1978 to David J. McElroy, the keyboard illustrated in FIGURE 17 includes key switch 125 and key switch 126, each having one of their two conductors connected to the fixed potential of conductor 123. In accordance with the teachings of the above cited patent, key switches 125 and 126 may then be employed as momentary contact on and off switches.

The other key switches 124 illustrated in FIGURE 17 are disposed in a matrix form, that is each key switch has one of its pair of conductors connected in a column and the other of its pair of conductors connected in a row. Tail portion 121 includes conductors 122 and conductor 123. Together these conductors available at tail 121 include all of the lines necessary to sense the closure of any of key switches 124, 125 or 126.

Flexible membrane 120 is preferably manufactured of a single sheet of flexible material. This single sheet may be constructed of vinyl, Mylar (registered trade mark) or polycarbonate. As will be further explained below, a vinyl sheet is preferable because this enables easier application of graphics to the second surface of the sheet.

The first conductive pattern illustrated in FIGURE 17 is preferably transfer printed onto the first surface of flexible membrane 120. A conductive ink formed of approximately 50% silver ink and 50% graphite ink may be employed for this conductive pattern. Other types of conductive ink could be employed instead. This is preferably applied to flexible sheet 120 by a silk screening or lithographic process. In addition, a conductive ink of the pure solvent type or of the ultraviolent light cure type may also be employed.

FIGURE 18 illustrates the insulative pattern applied to the first surface of flexible membrane 120 after the application of the first conductive pattern. This insulative pattern includes a plurality of small insulators 130. Each of the small insulators 130 is disposed on the previously deposited first conductive pattern at one of the crossover points 127 (illustrated in FIGURE 17). The insulative pattern is preferrably formed of an insulative ink transfer printed on the surface of flexible membrane 120 over the first interconnection pattern in a manner similar to the deposition of the first insulative pattern.

FIGURE 19 illustrates the second conductive pattern or jumper pattern. The second conductive pattern includes a plurality of conductors 140, each of which is disposed at a position corresponding to one of the crossovers 127 illustrated in FIGURE 17. The second conductive pattern is preferrably deposited on the first surface of the flexible membrane 120 over the combination of the first conductive pattern and the insulative pattern. This second conductive pattern may be applied in the same manner as the first conductive pattern. Application of insulators 130 and jumpers 140 to the crossover points 127 enables construction of one or more conductor crossing patterns on the surface of flexible membrane 120. This provision for a crossover pattern enables more complicated interconnection patterns to be formed on the flexible membrane 120 than would he possible without such crossing patterns. This enables construction of more complicated keyboards than would otherwise be possible.

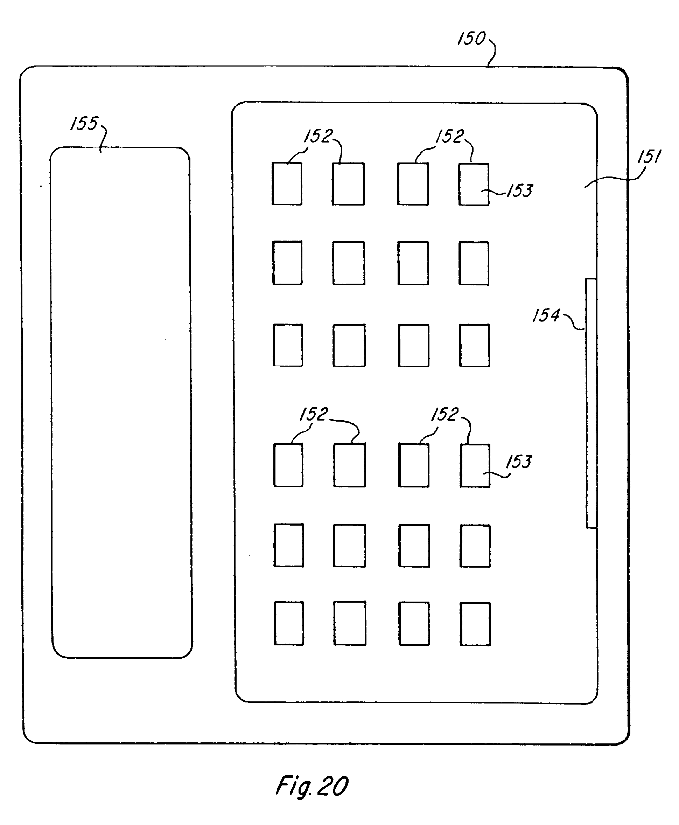

FIGURE 20 illustrates a view of the front case of an electronic apparatus employing the single sheet membrane keyboard of the present invention. FIGURE 20 illustrates front case 150. Front case 150 has a keyboard area 151. This keyboard area 151 has the same outline as the flexible membrane 120, with the exception of the tail portion 121. The keyboard portion 151 is preferrably substantially flat with the exception of a plurality of depressions 152. Each depression 152 is disposed at a location within keyboard surface 151 corresponding to one of the key switches 124, 125, or 126. In a preferred embodiment, front case 150 is constructed of an injection molded plastic. Because front case 150 is formed of plastic, keyboard surface 151 is nonconducting. Of course front case 150 may be formed in a different manner and from different material as long as keyboard surface 151 is nonconducting. Proper construction of the mold for front case 150 permits construction of a substantially flat keyboard surface 151 which has depressions 152 as described. The bottom of each depression 152 includes a conductive layer 153 disposed at the bottom thereof. This conductive layer 153 preferrably comprises a layer of conductive ink transferred printed into the bottom of the depressions 152. This transfer ink may be of the same type as employed in manufacture of the first and second conductive patterns placed upon flexible membrane 120.

Front case 150 contains a pair of apertures 154 and 155. Aperture 154 is preferrably a slot opening disposed within keyboard surface 151 at a position corresponding to tail portion 121 of flexible membrane 120. During assembly the tail portion 121 of the single sheet keyboard is inserted into slot 154 and the first surface including the interconnection pattern of flexible membrane 120 is glued on to keyboard surface 151. This assembly provides registration of each of the key switches 124, 125 and 126 with a corresponding depression 152 and conductive layer 153.

Also included within front case 150 is a display opening 155. In the preferred embodiment, a visual display such as a liquid crystal display, a light emitting diode display or a vacuum florescent display is placed within the case of the electronic apparatus so that it may be viewed through display aperture 155 within top case 150. This display is employed to communicate to the operator of the apparatus the results and the operational state of the apparatus. Other forms of communication between the apparatus and the operator are possible. As an example, an electromagnetic or piezoelectric transducer could be employed to enable musical tone or synthesized speech output. In such a case front case 150 must be constructed to accomodate the transducer rather than a visual display.

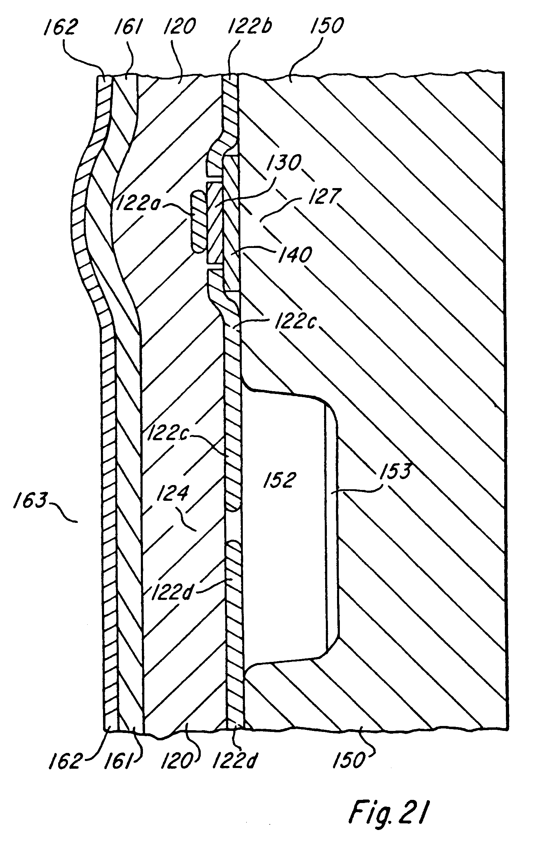

FIGURE 21 illustrates a cross sectional view of the membrane keyboard of the present invention. FIGURE 21 includes a view of a typical crossover portion 127 and typical key switch position 163.

Flexible membrane 120 is disposed substantially over the surface of top case 150. On the upper surface of flexible membrane 120, away from top case 150, is disposed a graphics layer 161 and a protective layer 162. Graphics layer 161 preferably includes characters, words, names and colors which properly identify each key switch position of the membrane keyboard. This graphics layer 161 enables proper operator identification of the various key switch positions of the membrane keyboard, thereby permitting the operator to properly select the desired key closures for the desired machine operation. Graphics layer 161 is preferably printed upon the top surface of flexible membrane 120 by an ordinary printing process. As noted above, it is preferable to employ a vinyl sheet for flexible membrane 120 because such vinyl material more easily accepts the printed graphic layer 161. Also placed upon the upper surface of the membrane keyboard is a protective layer 162 which may be composed of a transparent mylar layer. This protective layer preferably is employed to minimize wear and rub off of the graphics layer, thereby extending the useful life of the membrane keyboard.

On the other surface of flexible membrane 120, that is the surface which faces top case 150 of the apparatus, the first conductive pattern, the insulative pattern and the second conductive pattern are disposed. FIGURE 21 illustrates conductors 122a, 122b, 122c and 122d, each of which is formed as a part of the first conductive pattern. Conductor 122a is illustrated in cross section and passes approximately perpendicular to the cross sectional view illustrated in FIGURE 21. Conductors 122b, 122c and 122d preferably extend substantially in parallel to the cross sectional view illustrated in FIGURE 11. The region between conductors 122a, 122b and 122c forms a crossover area 127. As explained above, an insulative pattern is disposed upon the first surface of flexible membrane 120 at positions corresponding to the crossover portion 127. As illustrated in FIGURE 21, insulator 130 is disposed on top of conductor 122B and between conductors 122b and 122c. The second conductive pattern includes a jumper 140 which is disposed over the insulator 130 and is placed in contact with both conductors 122b and 122c of the first conductive pattern. As a result of this construction, a continuous electrical path from conductor 122b, through jumper 140 to conductor 122c is constructed. This continuous electrical path is insulated from the crossing electrical path of conductor 122a via insulative layer 130.

Also illustrated in FIGURE 21 is the operation of key 124 at key switch position 163. Key 124 includes a pair of conductors, 122c and 122d, which are disposed upon the surface of flexible membrane 120 in registration with a corresponding depression 152 in top case 150. This area of the keyboard is a key switch position 163. Pressure upon the external face of the membrane keyboard in the area of key switch position 163 causes membrane 120 to flex until both conductors 122c and 122d are in contact with conductive layer 153 placed at the bottom of depression 152. This simultaneous contact causes a continuous electrical path from conductor 122c through conductive layer 153 to conductor 122d. As explained above, this may be detected by proper sensing upon the conductors 122 appearing at the ends of tail portion 121 as a closed key switch. Removal of the pressure on the exterior of key switch position 163 causes flexible membrane 120 to regain its original position, thereby disconnecting the electrical path between conductors 122c and 122d. This disconnection of the electrical path is sensed as an open key switch.

## Claims

1. A keyboard structure for an electronic apparatus comprising:
a body of non-conductive material (150) providing a keyboard surface (151);
an electrically conductive layer (153) provided at a plurality of key switch positions on said body of non-conductivity material;
a keyboard sheet (120) of non-conductive material having opposing first and second surfaces, said first surface being disposed adjacent to and substantially covering said keyboard surface;
an interconnection pattern including a plurality of electrical conductors (132) disposed on said first surface of said keyboard sheet facing said keyboard surface and arranged to provide a pair of electrical conductors (122c,122d) in proximity at each of said key switch positions (163); and
said keyboard sheet including a plurality of keys (124), each of said keys (124) being respectively provided with a pair of said electrical conductors (122c,122d) on said interconnection pattern in proximity at each of said key switch positions (163) such that actuation of a particular key on said keyboard sheet causes a respective pair of electrical conductors corresponding to a particular key switch position to be moved into engagement with said electrically conductive layer (153) on said non-conductive keyboard surface to provide an electrical connection between said respective pair of conductors via said conductive layer at the selected key switch position; said body of non-conductive material (150) being provided with a plurality of spaced depressions (152) formed therein to extend partially through the thickness thereof, said spaced depressions opening onto said keyboard surface and respectively located at corresponding key switch positions;
each of said electrically conductive layers (153) being disposed at the bottom of respective depressions within said body of non-conductive material;
said keyboard sheet comprising a flexible membrane (120) of non-conductive material; and
said flexible membrane flexing in a direction toward said keyboard surface of said body to move a respective pair of electrical conductors corresponding to a particular key switch position into engagement with said conductive layer disposed at the bottom of the depression located at the respective key switch position in response to pressure on said second surface of said flexible membrane selectively applied at said particular key switch position in providing the electrical connection between said respective pair of conductors via said conductive layer at the selected key switch position.

2. A keyboard structure as set forth in claim 1, further characterized in that said interconnection pattern disposed on the first surface of said flexible membrane has a first set of electrical conductors (Fig. 17, 122) in which the respective pairs of electrical conductors in proximity at each of said key switch positions (163) are incorporated, said first set of electrical conductors being arranged to provide at least one crossover conductor group comprising a pair of conductors disposed on opposite sides of and transverse to another conductor interposed therebetween and in spaced relation thereto to define a crossover location (127);
a pattern of insulating material (Fig.18) overlying said first set of electrical conductors and including respective small insulators (130) disposed on said first set of electrical conductors at each of said crossover locations, each said small insulator being positioned over said another conductor and extending between said pair of conductors disposed on opposite sides thereof of the respective crossover conductor group; and
a second set of electrical conductors (Fig.19) including respective electrical conductors (140) disposed on said pattern of insulating material at each of said crossover locations, each said electrical conductor of said second set of electrical conductors being positioned over a small insulator and electrically connecting said pair of conductors of a respective crossover conductor group while being electrically insulated from said another conductor by said small insulator at the corresponding crossover location.

3. An electronic apparatus comprising:
an exterior case (Fig. 21, 150, 162) adapted to contain electronic components and having a body portion (150) of non-conductive material providing a keyboard surface (Fig. 20, 151) outwardly disposed with respect to the interior of said case and defining a plurality of key switch positions (163);
electronic circuit means (122a-122d, 140) disposed in said exterior case and operably connected to each of said plurality of key switch positions on said keyboard surface to provide a keyboard structure;
means (Fig. 1, 15) for performing an electronic function and generating a result in response to sensed electrical connections corresponding to particular key switch positions;
characterized in that said keyboard structure is constructed in accordance with either of claims 1 or 2.

## Patentansprüche

1. Tastaturaufbau für eine elektronische Einrichtung, mit:
einem Körper aus nicht leitendem Material (150), der eine Tastaturoberfläche (151) liefert;
einer elektrisch leitenden Schicht (153), die bei einer Mehrzahl von Tastenschalterpositionen an dem Körper aus nicht leitendem Material vorgesehen ist;
einer dünnen Tastaturlage (120) aus nicht leitendem Material mit gegenüberliegenden ersten und zweiten Oberflächen, wobei die erste Oberfläche nahe der Tastaturoberfläche angeordnet ist und diese im wesentlichen bedeckt;
einem Zwischenverbindungsmuster, das eine Mehrzahl von elektrischen Leitern (132) enthält, die auf der ersten Oberfläche der dünnen Tastaturlage angeordnet ist, die der Tastaturoberfläche gegenüberliegt, und die so vorgesehen sind, daß ein Paar von elektrischen Leitern (122c, 122d) in der Nähe einer jeden Tastenschalterposition (163) geschaffen wird; und
mit einer dünnen Tastaturlage mit einer Mehrzahl von Tasten (124), wobei jede dieser Tasten (124) mit einem Paar der elektrischen Leiter (122c, 122d) auf dem Zwischenverbindungsmuster in der Nähe einer jeden der Tastenschalterpositionen (163) versehen ist, so daß eine Betätigung einer besonderen Taste auf der dünnen Tastaturlage bewirkt, daß ein jeweiliges Paar von elektrischen Leitern entsprechend einer besonderen Tastenschalterposition in Eingriff mit der elektrisch leitenden Schicht (153) auf der nicht leitenden Tastaturoberfläche bewegt wird, um eine elektrische Verbindung zwischen dem jeweiligen Paar von Leitern über die leitende Schicht bei der ausgewählten Tastenschalterposition zu schaffen; wobei in dem Körper aus nicht leitendem Material (150) eine Mehrzahl von mit Zwischenraum angeordneten Vertiefungen (152) ausgebildet ist, die sich teilweise durch dessen Dicke erstrecken, und wobei die mit Zwischenraum angeordneten Vertiefungen sich an der Tastaturoberfläche öffnen und jeweils an entsprechenden Tastenschalterpositionen angeordnet sind;
wobei die elektrisch leitenden Schichten (153) am Boden der jeweiligen Vertiefungen innerhalb des Körpers aus nicht leitendem Material angeordnet sind;
wobei die dünne Tastaturlage eine flexible Membran (120) aus nicht leitendem Material enthält; und
wobei sich die flexible Membran in einer Richtung zu der Tastaturoberfläche des Körpers biegt, um ein jeweiliges, einer besonderen Tastenschalterposition entsprechendes Paar von elektrischen Leitern infolge des Drucks auf der zweiten Oberfläche der flexiblen Membran, der selektiv bei der besonderen Tastenschalterposition beim Schaffen der elektrischen Verbindung zwischen dem jeweiligen Paar von Leitern über die Leiterschicht bei der ausgewählten Tastenschalterposition ausgeübt wird, in Eingriff mit der leitenden Schicht zu bewegen, die am Boden der bei der jeweiligen Tastenschalterposition vorgesehenen Vertiefung angeordnet ist.

2. Tastaturaufbau nach Anspruch 1, dadurch gekennzeichnet, daß das auf der ersten Oberfläche der flexiblen Membran angeordnete Zwischenverbindungsmuster einen ersten Satz von elektrischen Leitern (Fig. 17, 122) aufweist, in dem die jeweiligen Paare von elektrischen Leitern in der Nähe einer jeden der Tastenschalterpositionen (163) enthalten sind, wobei der erste Satz von elektrischen Leitern vorgesehen ist, um wenigstens eine Überkreuzungsleitergruppe mit einem Paar von Leitern zu schaffen, die auf gegenüberliegenden Seiten eines weiteren, dazwischenliegenden und im Abstand dazu vorgesehenen Leiters und quer zu diesem weiteren Leiter angeordnet sind, um eine Überkreuzungsstelle (127) zu definieren;
wobei ein Muster aus isolierendem Material (Fig. 18) über dem ersten Satz von elektrischen Leitern liegt und jeweilige kleine Isolatoren (130) enthält, die auf dem ersten Satz von elektrischen Leitern bei jeder der Überkreuzungsstellen angeordnet sind, und wobei jeder kleine Isolator über dem weiteren Leiter angeordnet ist und sich zwischen dem Paar von auf gegenüberliegenden Seiten davon angeordneten Leitern der jeweiligen Überkreuzungsleitergruppe erstreckt; und
wobei ein zweiter Satz von elektrischen Leitern (Fig. 19) jeweilige elektrische Leiter (140) enthält, die auf dem Muster aus Isoliermaterial bei jeder der Überkreuzungsstellen angeordnet sind, wobei jeder elektrische Leiter des zweiten Satzes von elektrischen Leitern über einem kleinen Isolator angeordnet ist und das Paar von Leitern einer jeweiligen Überkreuzungsleitergruppe elektrisch verbindet, während er gegenüber dem weiteren Leiter durch den kleinen Isolator an der entsprechenden Überkreuzungsstelle elektrisch isoliert ist.

3. Elektronische Einrichtung mit:
einem äußeren Gehäuse (Fig. 21, 150, 162), das zur Aufnahme elektronischer Bauteile geeignet ist und einen Körperteil (150) aus nicht leitendem Material besitzt, der eine Tastaturoberfläche (Fig. 20, 151) liefert, die bezüglich des Inneren des Gehäuses außerhalb angeordnet ist und eine Mehrzahl von Tastenschalterpositionen (163) definiert;
elektronischen Schaltungsmitteln (122a-122d, 140), die in dem äußeren Gehäuse angeordnet und wirksam mit jeder der Mehrzahl von Tastenschalterpositionen auf der Tastaturoberfläche verbunden sind, um einen Tastaturaufbau zu schaffen; und
Mitteln (Fig. 1, 15) zum Ausführen einer elektronischen Funktion und zum Erzeugen eines Ergebnisses infolge der erfaßten elektrischen Verbindungen entsprechend besonderen Tastenschalterpositionen;
dadurch gekennzeichnet, daß der Tastaturaufbau gemäß irgendeinem der Ansprüche 1 und 2 ausgelegt ist.

## Revendications

1. Structure de clavier pour un appareil électronique comprenant:
un corps de matériau non conducteur (150) fournissant une surface de clavier (151);
une couche (153) conductrice électriquement disposée en une pluralité de positions de commutation à touches sur ledit corps de matériau non conducteur;
une feuille (120) de clavier en matériau non conducteur ayant des première et seconde surfaces opposées, ladite première surface étant disposée dans une position adjacente à ladite surface de clavier et recouvrant sensiblement celle-ci;
une configuration d'interconnexion comportant une pluralité de conducteurs électriques (132) disposés sur ladite première surface de ladite feuille de clavier en regard de la surface de clavier et agencée pour fournir une paire de conducteurs électriques (122c, 122d) à proximité de chacune desdites positions (163) de commutation à touches; et
ladite feuille de clavier comportant une pluralité de touches (124), respectivement, comprenant chacune une paire desdits conducteurs électriques (122c, 122d) sur ladite configuration d'interconnexion à proximité de chacune desdites positions (163) de commutation à touches, de telle sorte que l'actionnement d'une touche particulière sur ladite feuille de clavier conduit à ce qu'une paire respective de conducteurs électriques correspondant à une position particulière de commutation à touches soit déplacée pour coopérer avec ladite couche (153) électriquement conductrice sur ladite surface de clavier non conductrice pour obtenir une connexion électrique entre ladite paire respective de conducteurs par l'intermédiaire de ladite couche conductrice dans la position sélectionnée de commutation à touches; ledit corps de matériau non conducteur (150) étant pourvu d'une pluralité de creux espacés (152) formés à l'intérieur de celui-ci s'étendant partiellement à travers l'épaisseur de celui-ci, lesdits creux espacés s' ouvrant sur ladite surface de clavier et étant situés respectivement dans les positions correspondantes de commutation à touches;
chacune desdites couches (153) conductrices électriquement étant disposée au fond des creux respectifs à l'intérieur dudit corps de matériau non conducteur;
ladite feuille de clavier comprenant une membrane souple (120) en matériau non conducteur; et
ladite membrane souple fléchissant en direction de ladite surface de clavier dudit corps afin de déplacer une paire respective de conducteurs électriques correspondant à une position particulière de commutation à touches en coopération avec ladite couche conductrice disposée au fond du creux situé dans la position respective de commutation à touches en réponse à la pression sur ladite seconde surface de ladite membrane souple appliquée de manière sélective dans ladite position particulière de commutation à touches en disposant la connexion électrique entre ladite paire respective de conducteurs par l'intermédiaire de ladite couche conductrice dans la position sélectionnée de commutation à touches.

2. Structure de clavier selon la revendication 1, caractérisée en outre en ce que ladite configuration d'interconnexion disposée sur la première surface de ladite membrane souple comporte une première série de conducteurs électriques (figure 17, 122) dans laquelle les paires respectives de conducteurs électriques à proximité de chacune desdites positions (163) de commutation à touches sont incorporées, ladite première série de conducteurs électriques étant agencée pour fournir au moins un groupe de conducteurs de croisement comprenant une paire de conducteurs disposés sur les côtés opposés d'un autre conducteur interposé entre eux et transversalement à celui-ci, et dans une relation espacée par rapport à celui-ci afin de définir un emplacement de croisement (127);
une configuration de matériau isolant (figure 18) recouvrant ladite première série de conducteurs électriques et comportant de petits isolants (130) respectifs disposés sur ladite première série de conducteurs électriques à chacun desdits emplacements de croisement, chacun desdits petits isolants étant placé sur ledit autre conducteur et s'étendant entre ladite paire de conducteurs disposés sur les côtés opposés de celui-ci, du groupe de conducteurs de croisement respectifs; et
une seconde série de conducteurs électriques (figure 19) comportant des conducteurs électriques respectifs (140) disposés sur ladite configuration de matériau isolant dans chacun desdits emplacements de croisement, chacun desdits conducteurs électriques de ladite seconde série de conducteurs électriques étant placé sur un petit isolant et reliant électriquement ladite paire de conducteurs d'un groupe respectif de conducteurs de croisement tout en étant électriquement isolé dudit autre conducteur par ledit petit isolant dans l'emplacement correspondant de croisement.

3. Appareil électronique comprenant:
un boîtier extérieur (figure 21, 150, 162) apte à contenir des composants électroniques et ayant une partie (150) de corps en matériau non conducteur fournissant une surface de clavier (figure 20, 151) extérieure disposée par rapport à l'intérieur du boîtier et définissant une pluralité de positions (163) de commutation à touches;
des moyens (122a-122d, 140) à circuit électronique disposés dans ledit boîtier extérieur et connectés de manière fonctionnelle à chacune de ladite pluralité de positions de commutation à touches sur ladite surface de clavier pour obtenir une surface de clavier;
des moyens (figure 1, 15) effectuant une fonction électronique et générant un résultat en réponse à des connexions électriques détectées correspondant à des positions particulières de commutation à touches;
caractérisé en ce que ladite structure de clavier est réalisée conformément à l'une ou l'autre des revendications 1 ou 2.
